# EUROPEAN PATENT APPLICATION

(11) **EP 2 068 109 A2**
(43) Date of publication of application: **10.06.2009**
(21) Application number: 08021225.1
(22) Date of filing: 05.12.2008
(51) Int. Cl.: F28F 13/00, G01R 33/28, F25D 19/00

(54) **Fused porous material heat exchanger**

(30) Priority: 05.12.2007 US 999449
(71) Applicant: Varian, Inc., Palo Alto, CA 94304 (US)
(72) Inventor: Cosman, Jason William, Mountain View California 94304 (US)
(74) Representative: Mollekopf, Gerd Willi

(57) **Abstract**

A heat exchanger comprises a porous matrix of pellets (60) of a material selected to exhibit very high thermal conductivity and having nonplanar surfaces thereby to promote porosity. The pellets (60) are bonded together and to the interior of housing (64).

## Description

### FIELD OF THE INVENTION

This work is in a field of heat exchanger apparatus for cryogenic applications and particularly relates to cryogenic cooled NMR probes.

### BACKGROUND OF THE INVENTION

In the practice of analytic NMR measurements, RF channels are greatly enhanced by operation at cryogenic temperature. The Q of the RF coil, for example may then be of the order of 10⁴ compared to several times 10³ at ambient temperatures. Many cryogenic engineering problems are encountered in such apparatus for which heat is applied in a controlled fashion to the cold head for temperature regulation purposes and separately, heat is evolved from the RF circuit as a consequence of the resonant RF excitation process. A cryogenic refrigeration apparatus dissipates the thermal power developed at the coldhead, but the efficiency of the system is limited by the heat exchange process whereby the thermal power at the coldhead is transferred to a working fluid (usually He gas) returned (in a closed system) to the refrigeration apparatus.

Heat exchangers are an essential component in thermal transfer apparatus. Of the multitudes of designs, the present application is for heat transfer through intervening structure to a flowing gas with further particular requirements arising from the context of NMR apparatus. A prior art cryogenic cooled NMR probe employs a heat exchanger to cool the coldhead to 25K, where the cold He gas from the refrigerator is directed through a grooved channel in a metallic (Cu) body thermally bonded to the coldhead structure. An example of such prior art is the Varian, Inc. Cold Probe System (www.varianinc.com)

In any NMR probe attention is directed to the magnetic susceptibility of structural materials disposed in proximity to the sensitive volume. In many instances the bulk magnetic susceptibility of some components proximate the sensitive volume may be manipulated by alloys, selective plating, or the like. Electrically conducting materials disposed at some remove from the sensitive volume may still introduce deleterious effects to measurements through eddy currents induced in such conductors, which in turn produce spurious magnetic field components at the sensitive volume. While compensatory techniques are employed to ameliorate these effects, best practice is to minimize eddy current sites, usually by distancing same from modulated magnetic fields, especially, pulsed field gradients.

### SUMMARY OF THE INVENTION

The invention is defined in claims 1 and 6, respectively. Particular embodiments are set out in the dependent claims.

The present work utilizes a heat exchanger particularly optimized for operation in a cryogenic cooled NMR probe. The heat exchanger comprises an aggregate of pellets packed into the heat exchanger housing, adjacent such pellets mutually bonded together and to adjacent interior walls of the heat exchanger housing. The pellets exhibit very low (to vanishing) electrical conductivity, high thermal conductivity and high heat capacitance. Coolant gas flowing through the resulting matrix removes heat from that matrix. The matrix exhibits excellent porosity for characteristic pellet dimensions in the range 0.01D to 0.25D, where D is the hydraulic diameter of the heat exchanger shell or housing. The coldhead heat exchanger for a cryogenic cooled NMR probe is necessarily so located to efficiently transport heat away from an RF coil for exciting a sample disposed in the sensitive volume of the probe. That condition places the heat exchanger in a degree of proximity to the RF coil(s). Although sufficiently displaced from the sensitive volume to preclude direct interference with the quiescent magnetic properties of the sensitive volume, the present heat exchanger minimizes the incidence of eddy currents contributing to parasitic magnetic field components at the sensitive volume.

### BRIEF DESCRIPTION OF THE DRAWINGS

Figure 1 shows the context of the present heat exchanger in a cryoprobe NMR system.
Figure 2 describes some principal subcomponent relationships in the coldhead.
Figure 3a represents a section through the present heat exchanger structure.
Figure 3b is an expanded view of a portion of the heat exchanger of figure 3a.

### DETAILED DESCRIPTION OF THE INVENTION

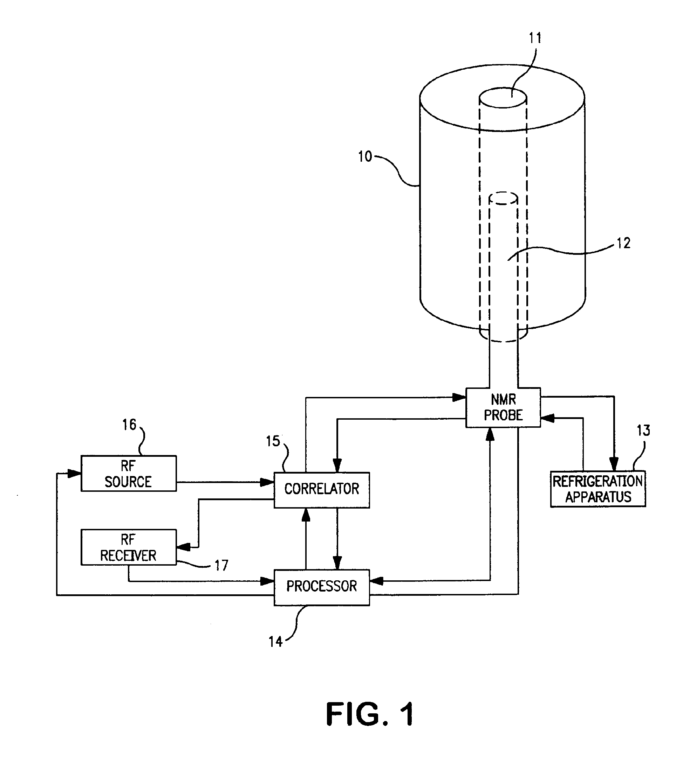

Figure 1 serves to illustrate conceptually the context of this work within an NMR system. An NMR probe **12** is disposed within the bore **11** of a superconducting magnet **10.** (At the outset, it should be noted that the disposition of the NMR probe imposes a spatial constraint on the components of the NMR probe. A sample for analysis is presented in a sample vessel (not shown) inserted in a probe **12.** The probe **12** inductively couples to the nuclear spins of the sample (not shown) for excitation/acquisition through at least a first RF excitation channel(s) from an RF source **16** and separately for signal acquisition through receiver channel(s) to RF receiver **17.** Excitation and resonance signal receive functions often share a common probe coil for non-concurrent operation through correlator **15,** but multiple coils are frequently employed to serve different functions, or the same coil may be organic to a multiply tuned circuit to serve a variety of functions, such as to furnish spin decoupling, field-frequency lock, and the like. The receive channel ordinarily includes a preamplifier and RF demodulator, phase detector, analog-to-digital conversion (ADC) and various signal processing apparatus, together denoted for simplicity here as RF receiver **17.** A digital processor **14** to effect averaging, Fourier transformation, storage, excitation control and general apparatus monitoring functions. More recently, some of these functions are consolidated in a direct digital receiver, but these variations are not critical to the understanding or operation of the present probe circuit adjustment apparatus. An input /output module provides for instruction of the processor **14,** provision for display of data and general operator intervention. The probe operates at cryogenic temperatures as suggested by refrigeration apparatus **13** pictured. Cooling of the probe occurs with circulation of a coolant (ordinarily, helium) through a heat exchanger located within the probe **12.** The entire probe **12** is axially elongate to place the RF coil of the probe at the position of maximal magnetic homogeneity while distancing other probe components from that location.

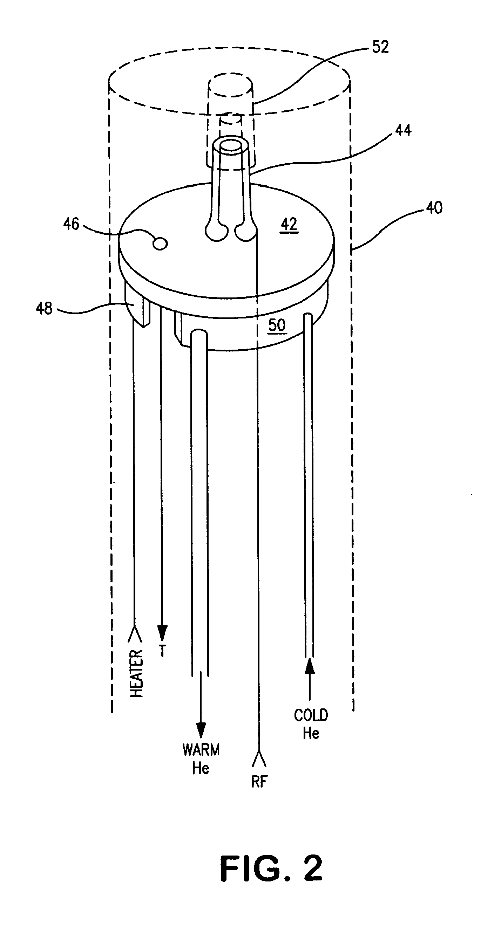

Fig. 2 is a schematicized illustration of those components of a cryogenic cooled NMR probe as are referenced in this description. A vacuum tight housing **40** encloses the coldhead which features a coldhead base **42** supporting RF coil **44** and thermal sensor **46.** A heater **48** is thermally joined to base **42** as is heat exchanger **50.** Thermal regulatory apparatus utilizes the signal **T** to control the heater **48** for thermally balancing heat transfer from coldhead base **42** through heat exchanger **50** thereby establishing dynamic thermal equilibrium at a selected temperature. The details of the thermal regulatory circuit (not shown) and the cryogenic refrigerator (not shown) are outside the scope of this work and are well known.

During NMR measurement, RF power in a range up to a few watts may be applied to RF coil **44** as pulses ranging from microseconds to milliseconds in duration. (The present heat exchanger can sustain continuous application of RF power in the ranges described, but this is not often practiced in modem NMR studies.) A significant fraction of the RF power dissipated from RF coil **44** does not couple to the sample within the room temperature blind bore **52** of housing **40.** This stray power appears ultimately as thermal power absorbed by the coldhead and transferred through heat exchanger **50** to the flowing coolant (He) stream. It is important to observe that this environment is necessarily quite time dependent as contrasted with many heat exchanger applications where thermal conditions are steady state in nature or rather slowly varying. In the NMR application, the ability to maintain the thermal condition within the designed regulatory specification is limited by the heat exchanger efficiency subject to repetitive RF pulse sequences.

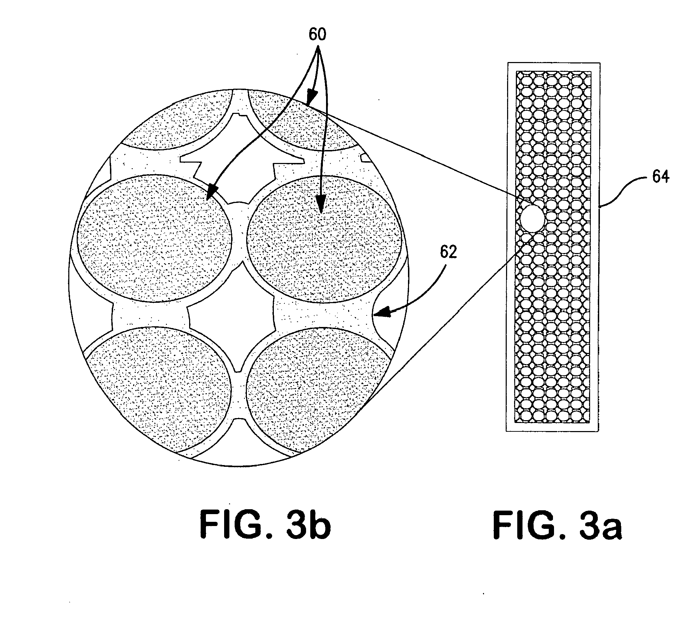

A cross section of the present heat exchanger and a detail thereof is shown in figures 3a and 3b, where adjacent pellets **60,** bearing surface coating (wetting agent) **62,** are bonded together and to the interior walls of the heat exchanger housing **64.** The surface coating **62** is a wetting agent to secure the desired bonding upon activation of the wetting agent. Selected practical embodiments include thin metallized films fused at the melting temperature of the metal. Reference herein to "pellets" does not connote any specific geometry, per se, for these discrete bodies. These bodies may be spherical, ellipsoidal, cylindrical, irregular, etc. However, polygonal bodies having significant planar areas would not be preferred for most purposes, as will become apparent. For the present purpose, pellets having some planar surface portions, e.g., end faces of cylinders, comprise substantially non-planar surfaces if the packed aggregate of the pellets contact adjacent pellets at points or along lines in such surfaces. These pellets will be disposed within a housing having dimensions defining a cross section of "hydraulic diameter" D. Hydraulic diameter is a well known calculational convenience in analyzing and comparing fluid flow characteristics in passages of non-circular or irregular dimension. In the matter of dimension, the pellets exhibit a maximum extension in the range of 0.05 D to 0.25D.

A prototype heat exchanger has been constructed using cylindrical copper segments 0.04" diameter by 0.05" axial length, each bearing a wetting agent coating in the form of a tin film (0.0003" thick prior to fusing). The coated pellets fill housing (in this example, a cylinder of 0.375"diameter by 2.5" gross dimension). The packed pellets are subject to a temperature sufficient to melt the tin, e.g., activate the wetting agent, while a modest compressive force (about 10 psi) is applied to the planar faces of the heat exchanger housing. As the tin melts, the adjacent pellets are forced into intimate point contact and the applied pressure and surface tension draws a portion of molten tin proximate each junction point to enclose such junction point in a tin jacket. There results excellent thermal conduction through such points and the surrounding tin jackets. In the pellet surface region between the jacketed point contacts, the coating thickness is further reduced, thereby enhancing the volume of the voids between pellets, e.g., increasing the thermal transfer area for the fluid coolant flowing through the matrix of voids. Desirably, the volumetric composition of the matrix is in the range 55 -70 % pellet material, with the balance, void. Random pellet shapes and/or orientations yields isotropy in fluid conductance through the matrix. Cylindrical pellets have been employed in the present prototype for convenience.

In a preferred embodiment for disposition within an NMR probe, the pellet comprises a material that exhibits a very low electrical conductivity, a high thermal conductivity and a high heat capacity. (The low electrical conductivity property contributes certain enhancements for those applications where the heat exchanger is disposed in proximity to rapidly changing RF and/or magnetic fields.) The pellet properties include a capability to form (perhaps in conjunction with a wetting agent) a mutual bond or surface adhesion with other pellets in order to achieve gross thermal conductance across aggregates of pellets in mutual contact. In the present work, no distinction is intended as to the manner of effecting a bond between contacting surfaces of adjacent pellets and between the heat exchanger housing and pellet surfaces adjacent thereto. Fusing, brazing, and the like are regarded as equivalent processes to obtain surface joinder of contacting surfaces of adjacent pellets. As a practical matter, this latter property is conveniently obtained, as described above, by applying a surface coating **62** to the pellets **60** where the surface coating material is a satisfactory wetting agent for the pellet material and exhibits a lower melting point in relation to the melting point of the pellet material. A matrix of pellets **60** is formed by fusing the aggregate of pellets **60** in the housing to one another and to the interior surfaces of the heat exchanger housing **64,** as by melting the coating material **62,** or by cold welding or other appropriate bond. The resulting matrix of bonded pellets presents a porous volume characterized by the high thermal conductivity of the pellet material.

As a composite body, a coated pellet 60 may better acquire the desired electrical and thermal conductance and thermal capacitance as gross, or bulk properties. Exemplary of this approach is a preferred employment of sapphire as a pellet material thereby obtaining preferred electrical conductivity of zero with thermal conductivity of 5x10³ watts/ meter ·K (at 25K) and thermal capacity of 0.7 Joules/K·kg (at 25K). It was remarked above that metallization applied to the pellet surface has been employed as a practical matter. In the present work, a film of tin plated to a thickness of 0.0003" on copper pellets has been employed to serve as a wetting agent, merely as a representative and easily managed coating. Although metallization conflicts with the desiderata of vanishingly low electrical conductivity, a reliable bonding agent results. Metallized surfaces are capable of supporting (undesirable) eddy currents induced by the pulsed RF excitation of the sample. These eddy currents in turn are capable of supporting parasitic magnetic field components that can disturb the magnetic field homogeneity at the location of the sample. Consequently it is desired to reduce the presence of conductive material proximate this region and such reduction may be achieved in either or both the conductivity and the quantity of (conductive) material.

Although copper was employed for the pellet material for this prototype that choice should not be construed as a preference in view of the desiderata of reduced quantity of electrically conductive material proximate the pulsed RF and/or gradient magnetic fields of an NMR probe. The property of low electrical conductivity is a convenient proxy for the desired reduction of the mass of conductive material in proximity to changing RF or magnetic fields as experienced in the context of an NMR probe. In contexts where deleterious effects of transient RF or magnetic fields are absent or irrelevant, the electrical conductivity properties of the pellet material are not critical.

The present porous heat exchanger replaces the heat exchanger of prior art in this particular environment which used a body of solid copper with machined fluid passage grooves for heat transfer from the fluid to the body. It is immediately recognized that this prior art featured a quantity of solid electrical conductor in close proximity to the RF coil and this quantity of conductor is massively reduced for the present heat exchanger compared to such prior art. One of skill in the art understands that this reduction of conducting material close to the RF coil carries with it a reduction in the parasitic eddy currents induced in such proximate conducting structure. As a consequence, the RF resonant background signal arising from parasitic magnetic field broadening from eddy current effects (induced in the heat exchanger structure), is significantly reduced. In this work, the enhanced efficiency of the present heat exchanger over the solid copper heat exchanger of prior art yields a greatly reduced quantity of conductive material proximate the RF coil. For this reason, the signal-to-noise parameter for NMR spectra is enhanced.

Prior to incorporation of the present heat exchanger into the cryogenically cooled NMR probe, several different heat exchangers of diverse designs were built and bench tested for efficiency. For this purpose, efficiency is taken as heat load/ ( T_{heat exchanger} - Tₒᵤₜ). That is, an efficient heat exchanger more nearly heats the gas to the temperature of the heat exchanger. These candidate designs were characterized by the same gross dimensions and differed chiefly in the heat transfer medium. It is evident that area of the heat exchange medium promotes heat exchange by contact with a flowing gas. Four different heat exchangers were compared: the "pellet" construction disclosed herein; a machined spiral groove passage device, e.g., the prior art; a screened passage device; and a "wool" device. The machined spiral groove, as described, comprised a first and second set of spiral turns machined as grooves on a copper cylinder housed in tightly fitted and hermetically sealed copper housing. The aggregate gross length of the grooves yields a measured aggregate area exposed to the coolant flow. The screen device comprises a plurality of woven copper fabric discs spaced apart by a similar plurality of punched apertured discs. The wool device employed a measured weight of copper wires (0.002" diameter) packed into the heat exchanger housing. Table 1 shows the heat exchange media area and the measured efficiency.

**Table 1**

| Heat exchanger | Efficiency Watts/ΔT | Surface area inch² |
|---|---|---|
| (Prior art) spiral groove | 1.8 | 1.4 |
| Copper wool | 2.2 | 87 |
| Copper screen | 3.1 | 18 |
| Pellets (lead coated Cu) | 4.75 | 11.2 |

The area for each of these examples is obtained from simple geometry, or for the copper wool example from the gross weight and copper fiber dimensions. For the pellet type heat exchanger of the present work, the coated pellets (of uniform known dimensions) were weighed to obtain the maximum potential heat exchange area available. The thermal measurements were obtained from the calibrated heat sensor 46 and from another heat sensor (not shown) disposed at the warm helium outlet.

It is immediately noted that the heat transfer coefficient is the same for substantially all examples and that, surprisingly, the efficiency does not track the trend in the area of the heat transfer medium. While the heat transfer elements of the several examples, other than copper wool, all enjoy conductive conjunction between the component elements, the very strong numeric advantage in area of the wool device over the pellet embodiment (greater than a factor of 7) would be expected to provide a greater relative thermal efficiency. Instead, the pellet design of the present work exhibits more than a factor of two advantages in thermal efficiency over the copper wool example. The heat exchanger of the present work, in relation to the spiral grooved prior art, exhibits an advantage of 264% in thermal efficiency and this is believed attributable to the greater surface area available for the present pellet type design. The area quoted in table 1, above, for the pellet type heat exchanger is a maximum value and is expected to diminish after completion of the fusing process as described.

In comparison to prior art, The present heat exchanger facilitates greater heat transfer efficiency for an NMR probe by a factor of 2.6, while simultaneously reducing the mass of conductive material to provide improved signal-to-noise characteristics to NMR spectra.

The enhanced thermal efficiency achieved by the present porous heat exchanger is not limited to use within the confines of the NMR probe. Heat exchangers for operation in other aspects of the cryogenic refrigeration system(s) of this equipment profit from the present work. Modem NMR studies require the magnetic fields of high intensity and surpassing homogeneity achieved with superconducting magnets. The cryogenic refrigeration systems for such systems profit from the advantage of higher efficiency in heat exchangers operating at cryogenic temperatures. In this aspect of use the stringent constraints of electrical conductivity of the pellet components is relaxed because the heat exchanger can be rather remote from RF fields. However, the realization of enhanced thermal efficiency for the heat exchanger yields a device capable of more stringent (smaller) dimensional constraints. Accordingly the desired high thermal conductance may be obtained from discrete copper pellets suitably coated. Such_a heat exchanger for use in other aspects of cryogenic apparatus has been constructed with copper pellets, 0.04" in diameter by 0.08" in length, coated with tin film approximately 0.0003" thick. This embodiment replaced a prior heat exchanger based upon a solid copper cylinder 4.3" outer diameter, 2.6" inner diameter by 2.4" in length bearing spiral fluid passage machined grooves. Equal or better thermal power transfer was achieved in a device of axial length 0.6", a reduction of 400% and a reduction in weight from 6.9 lbs to 1.8 lbs. Accordingly the cost and mass required for this heat exchanger were greatly reduced while the heat exchange efficiency was increased from
8 watts/K to 90 watts/K.

Although this invention has been described with reference to particular embodiments and examples, other modifications and variations will occur to those skilled in the art in view of the above teachings. Although the use of a metallized surface for the heat exchanger pellets is described here for a simple method of manufacture, other forms of pellet-to-pellet bonding is possible. It should be understood that, within the scope of the appended claims, this invention may be practiced otherwise than as specifically described.

## Claims

1. In a heat exchanger (50) for operation in a cryogenic cooled apparatus, said heat exchanger comprising:
a thermally conductive housing (40, 64) having interior surfaces defining a cross section of hydraulic dimension D; and
a plurality of pellets (60) packed into said housing (40, 64), each pellet comprising:
substantially non-planar surfaces, being thermally conductive and in bonded relationship to adjacent pellets, said interior surfaces in bonded relationship to portions of surfaces of pellets adjacent thereto,
whereby said pellets (60) form a porous matrix comprising a characteristic dimension in the range 0.05D to 0.25D.

2. The heat exchanger of claim 1, wherein said heat exchanger is disposed at the coldhead (42) of an NMR probe (12).

3. The heat exchanger of claim 1 or 2, wherein each pellet (60) comprises a material exhibiting a ratio of electrical conductivity to thermal conductivity that is small compared to unity.

4. The heat exchanger of claim 1, 2 or 3, wherein each said pellet (60) comprises a surface coating (62), said surface coating comprising a wetting agent to secure bonding of adjacent pellets.

5. The heat exchanger of claim 4, wherein said surface coating (62) comprises a material having a melting point lower than the melting point of said pellet material.

6. A method of making a heat exchanger (50) comprising a porous array of thermally conducting pellets (60), said pellets comprising substantially non-planar surfaces, said method comprising the steps of:
a) providing a heat exchanger housing (40, 64);
b) providing a plurality of said pellets (60) sufficient fill said housing (40, 64); and
c) mutually bonding contacting surfaces of said pellets (60) to form an array of pellets and bonding surfaces of said array to the inner surface of said housing (40, 64).

7. The method of claim 6, wherein said steps of bonding comprise applying a wetting agent to the surfaces of said pellets (60) and the inner surface of said housing (40, 64).

8. The method of claim 6 or 7, comprising the steps of concurrently heating said housing (40, 64) and pellets (60) to a temperature sufficient to activate said wetting agent while applying pressure to said pellets.
